# EUROPEAN PATENT APPLICATION

(11) **EP 1 350 807 A1**
(43) Date of publication of application: **08.10.2003**
(21) Application number: 01999240.3
(22) Date of filing: 04.12.2001
(51) Int. Cl.: C08J 7/00, C09K 13/06

(54) **ETCHANT FOR THERMOPLASTIC POLYIMIDE RESIN**

(30) Priority: 07.12.2000 JP 2000373268
(71) Applicant: TORAY ENGINEERING CO., LTD., Kita-ku, Osaka-shi, Osaka 530-0005 (JP)
(72) Inventor: AKITA, Masanori, c/o TORAY ENGINEERING CO., LTD., Otsu-shi, Shiga 520-2141 (JP); URASHIMA, Toshio, c/o TORAY ENGINEERING CO., LTD., Chuo-ku, Tokyo 103 (JP); OYAMA, Minoru, Chigasaki-shi, Kanagawa 253-0005 (JP); SUZUKI, Atsushi, c/o RAYTEC Inc., Kawagoe-shi, Saitama 350-0833 (JP); HASHINO, Yuko, c/o RAYTEC Inc., Kawagoe-shi, Saitama 350-0833 (JP); KANEKO, Miharu, c/o RAYTEC Inc., Kawagoe-shi, Saitama 350-0833 (JP)
(74) Representative: Sturt, Clifford Mark
(86) International application number: JP0110565
(87) International publication number: WO02046280

(57) **Abstract**

The invention concerns an etching liquid appropriate for etching thermoplastic polyimide resins. The etching liquid it is composed of an aliphatic amino-alcohol whose number of carbon is equal or inferior to 4 having an amino group or an imino group and a hydroxyl group in a molecular thereof, and a tetra alkyl ammonium hydroxide aqueous solution.

## Description

### BACKGROUND OF THE INVENTION

### Technical Field of the Invention

The present invention concerns an etching liquid for thermoplastic polyimide resin.

### Related Art

Conventionally, a through hole or the like is formed by punching, laser etching or others on a non thermoplastic polyimide resin film of a so-called metal plated polyimide resin film substrate obtained by binding a commercialized non thermoplastic polyimide resin film, for example, Kapton (trade name of DuPont-Toray Industries Co., Ltd.), Apical (trade name of KANEGAFUCHI CHEMICAL CO., LTD.) or Upilex (trade name of UBE Industries, LTD.) and a metal foil (for example, copper foil, stainless steel foil, or the like) by an adhesive. However, as it is difficult to form device holes having a wiring such as flying lead, complex and fine via holes or the like by punching or laser etching, generally, liquid etching is used in case of forming such device holes or the like.

For example, the etching is performed using an inorganic alkali base etching liquid such as a caustic alkali solution with a non hydrazine base amine compound or isopropyl alcohol with caustic alkalis, or an organic alkali etching liquid composed of isopropyl alcohol and quaternary ammonium hydroxide.

However, even if such etching liquid is appropriate for the etching of non thermoplastic polyimide resin film, it is inappropriate for the etching of thermoplastic polyimide resin film as it causes cracking in the etched portion or for other reasons. In addition, recently, thermoplastic polyimide resin base adhesives presenting an excellent heat resistance have been used, in place of conventional epoxy resin or acryl resin base adhesives, as an adhesive for binding a polyimide resin film and a metal foil. However, thermoplastic polyimide resin base adhesives present characteristics more difficult for etching than the non thermoplastic polyimide resin.

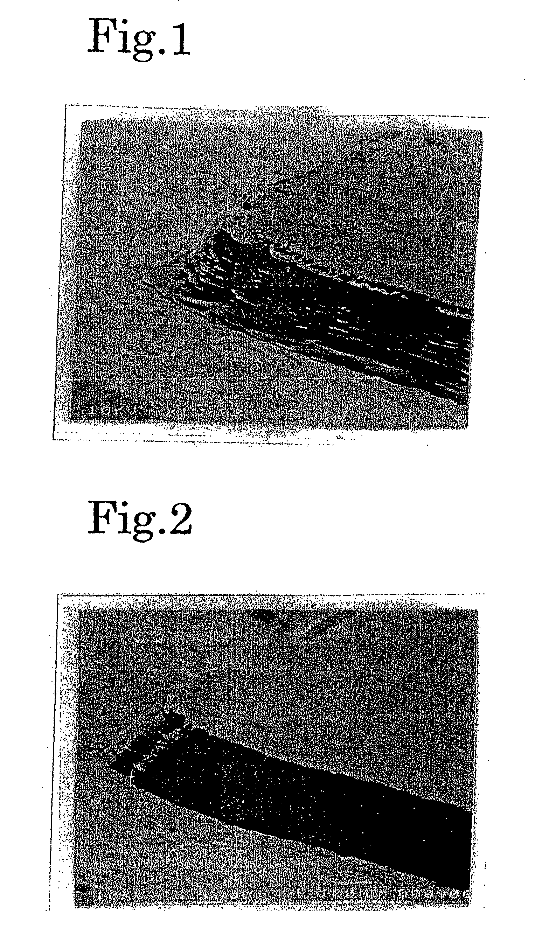

Consequently, when the non thermoplastic polyimide resin film of metal plated polyimide resin film substrate obtained by binding a non thermoplastic polyimide resin film and a metal foil by a thermoplastic polyimide resin base adhesive is etched using the aforementioned conventional inorganic alkali base etching liquid or organic alkali etching liquid, the thermoplastic polyimide resin becomes such a state as overhanging over the peripheral wall of the etching hole, remains annularly on the metal foil surface of the hole bottom (see Figs. 1 and 7) or provokes similar problems, and such resin residue can not be removed by an ordinary method such as dis-mire treatment by permanganate or the like.

The present invention has been devised in view of the aforementioned defects and has an object to provide an etching liquid appropriate for etching the thermoplastic polyimide resin.

### SUMMARY OF THE INVENTION

The etching liquid for thermoplastic polyimide resin according to the present invention for achieving the aforementioned object is characterized by that it is composed of an aliphatic amino-alcohol whose number of carbon is equal or inferior to 4 having an amino group or an imino group and a hydroxyl group in a molecular thereof, and a tetra alkyl ammonium hydroxide aqueous solution.

It should be appreciated that monoethanolamine is preferable as aliphatic amino-alcohol, and tetra methyl ammonium hydroxide aqueous solution or tetra ethyl ammonium hydroxide aqueous solution as tetra alkyl ammonium hydroxide aqueous solution.

### BRIEF DESCRIPTION OF DRAWINGS

Fig. 1 is a SEM picture of trench holes showing the residue presence state before etching by an etching liquid according to the present invention;
Fig. 2 is a SEM picture of trench holes showing the residue absence (residue removed) state after etching by the etching liquid according to the present invention;
Fig. 3 is a SEM picture of wiring sections of device holes showing the residue presence state before etching by an etching liquid according to the present invention;
Fig. 4 is a SEM picture of wiring sections of device holes showing the residue absence (residue removed) state after etching by an etching liquid according to the present invention;
Fig. 5 is a microscopic picture showing the surface state of "Upilex-VT" in case of using a conventional etching liquid (TPE-3000);
Fig. 6 is a microscopic picture showing the peripheral wall section of trench holes in case of using a conventional etching liquid (TPE-3000); and
Fig. 7 is a SEM picture showing a state where the residue is not removed by isopropanol / tetra methyl ammonium hydroxide base etching liquid.

### DETAILED DESCRIPTION OF THE PREFERRED EMBODIMENTS

Though the etching liquid according to the present invention is used for thermoplastic polyimide resin, the thermoplastic polyimide resin may be of any form such as film element, adhesive residue, or the like.

In short, thermoplastic polyimide resin used as substrate for manufacturing circuit boards is formed into a film element, and used alone, or laminated with the other resin films or metal foils, while the etching liquid according to the present invention can be used for either of them and, furthermore, it can also be used for removing residue of thermoplastic polyimide resins used for such laminating, and so on.

Thus, the term "etching" in the present invention means not only etching of a general film surface, but also, etching of larger notion including etching for removing adhesive residue, or others.

It should be appreciated that representative examples of thermoplastic polyimide resin used as polyimide resin film substrate comprise those including, in addition to monomer ingredient constituting raw material of non thermoplastic polyimide resin, monomers of diamine, tetra carboxylic anhydrate or the like having binding groups such as -CH₂-, -O-, -S-, CO- or others presenting low polarity and high flexion introduced into the main chain, monomer ingredients of aliphatic tetra carboxylic anhydrate or the like having bulky phenyl groups or bicyclic rings.

Besides, representative examples of thermoplastic polyimide resins used as adhesive comprise those obtained from diaminobenzophenone and benzophenone tetra carboxylic dianhydrate, and laminated polyimide resin film substrate using such thermoplastic polyimide resin base adhesives is not limited to metal plated ones, but it may be the one obtained by adhering polyimide resin films each other, and for the latter, it may be any of those obtained by adhering non thermoplastic polyimide resin films each other, or adhering a non thermoplastic polyimide resin film and a thermoplastic polyimide resin film, and further, adhering thermoplastic polyimide resin films each other, and so on.

Moreover, such adhesive may be in either of paste form or film form, so long as it is based on a thermoplastic polyimide resin. Representative examples of commercialized thermoplastic polyimide resin film comprise "Upilex-VT" made by UBE Industries LTD., and at the same time, as an example of polyimide resin film substrate wherein a thermoplastic polyimide resin base adhesive layer is formed on a non thermoplastic polyimide resin film, "Neoflex Series II" made by MITSUI CHEMICAL, INC. can be cited.

Moreover, representative examples of non thermoplastic polyimide resin used as polyimide resin film substrate comprise polyimide composed of pyromellitic anhydride (PMDA) and oxydianiline (ODA), polyimide composed of biphenyl tetra carboxylic anhydrate (BTDA) and p-phenilenediamine (PDA), and copolymers obtained from these monomers.

To be more specific, commercialized "Kapton" made by DuPont-Toray Industries Co., Ltd., "Apical" made by KANEGAFUCHI CHEMICAL CO., LTD., "Upilex-S" made by UBE Industries, LTD., and so on can be cited and, at the same time, as copper plated polyimide resin film substrate made by binding these non thermoplastic polyimide resin films and a cooper foil with a thermoplastic polyimide resin base adhesive, "Neoflex Series I" made by MITSUI CHEMICAL, INC. , "Upisel" made by UBE Industries, LTD. and so on can be cited.

Moreover, the etching liquid according to the present invention can be obtained by mixing water-soluble low molecular weight aliphatic amino-alcohols, namely, water-soluble aliphatic amino-alcohols whose number of carbon is equal or inferior to 4 having an amino group or an imino group and a hydroxyl group in a molecular thereof, such as monoethanolamine, diethanolamine, α -amino-isopropanol, 2-aminobuthanol and so on, and a tetra alkyl ammonium hydroxide aqueous solution such as tetra methyl ammonium hydroxide (tetra methyl ammonium hydroxide), tetra ethyl ammonium hydroxide (tetra ethyl ammonium hydroxide) and so on.

Such tetra alkyl ammonium hydroxide aqueous solution is an organic alkali aqueous solution, and the organic alkali aqueous solution has a property to hydrolyze the polyimide resins. On the other hand, water-soluble aliphatic amino-alcohols has a property to accelerate penetration of organic alkali into the polyimide resin and, at the same time, to elude hydrolysis products of the polyimide.

It should be appreciated that aliphatic amino-alcohols generally become less water-soluble when the number of carbon increases, reducing the compatibility with the tetra ammonium hydroxide aqueous solution, so those of low number of carbon is preferable. Monoethanolamine is especially preferably as it is highly water-soluble, it penetrates easily into polyimide, it is highly soluble in polyimide hydrolysis products, and moreover, it can be obtained easily in terms of industry.

For these reasons, it is preferable to combine monoethanolamine with tetra methyl ammonium hydroxide aqueous solution or tetra ethyl ammonium hydroxide aqueous solution. Ordinarily, the ratio between an amino alcohol such as monoethanolamine or the like and the tetra methyl ammonium hydroxide aqueous solution (concentration of tetra methyl ammonium hydroxide being 25 weight %) is preferable of the order of 3 : 1, and the content of tetra methyl ammonium hydroxide constituting organic alkali ingredient in the liquid is preferably between 4 wt % (included) to 15 wt % (included).

Because, if the organic alkali content is low, the processing takes more time, and if the organic alkali content is excessive, chemicals cost increases and, moreover, the proportion of moisture in the liquid increases relatively against the amino alcohol when 25% aqueous solution is used, altering the etching performance of thermoplastic polyimide resin film or non thermoplastic polyimide resin and, consequently, an appropriate control becomes difficult, jeopardizing the operation and the economy.

It should be appreciated that the quantity of organic alkali ingredients and the quantity of amino alcohol such as monoethanolamine or the like can be controlled by the potential difference titration method through the titration with hydrochloric acid of a predetermined concentration.

Besides, as for etching processing conditions, the liquid temperature is preferably in a range of 60 °C to 80 °C, and the processing time is preferably in a range of 1 minute to 60 minutes. Because, when the temperature is low, the reaction takes time, and on the contrary, if it is too high, resins other than thermoplastic polyimide resin are damaged, or, moisture evaporation or odor emancipation from organic alkali ingredients increase, resulting in the deterioration of working environment.

Consequently, the etching liquid according to the present invention allows to remove neatly by a single stage processing adhesive residue (thermoplastic polyimide resin residue) on the hole peripheral wall or the metal interface, generated in case of etching processing of, for example, a metal plated polyimide resin film substrate made by binding a non thermoplastic polyimide resin film and a metal foil by a thermoplastic polyimide resin base adhesive, by a conventional method using non hydrazine base inorganic alkali base etching liquid, and moreover, the etched surface can be smoothed.

It is supposed that these effects can be obtained, because, the etching liquid according to the present invention can etch slowly the non thermoplastic polyimide resin and, on the other side, can etch the thermoplastic polyimide resin relatively rapidly, compared to such conventional etching liquid, in other words, because it can etch in a way to give the etching of thermoplastic polyimide resin priority over the etching of non thermoplastic polyimide resin and, furthermore, to keep the progress balance of both etchings substantially constant.

Now, examples shall be described.

### [Example 1]

The "Upilex-S" side of a polyimide resin film substrate (size 5cm x 5 cm, thickness 65 µm) obtained by heat pressing a "Upilex-S" (thickness 50 µm) made by UBE Industries LTD., on a "Upilex-VT" (thickness 15 µm) made by the same company was coated with a cover film of polypropylene.

Then, the same was soaked in an etching liquid composed of 300 weight parts of monoethanolamine and 100 weight parts of 25% tetra methyl ammonium hydroxide aqueous solution and heated to 80 °C, and the thickness variation of the substrate was measured.

It should be appreciated that the etching liquid was composed of 73.7 wt% of monoethanolamine, and 6.07 wt% of tetra methyl ammonium hydroxide. Table 1 shows the measurement results of the substrate thickness. The substrate thickness was measured by a micrometer (model: 1 D-C112) made by MITSUTOYO Corporation.

**Table 1**

| | | | | | | | | | | |
|---|---|---|---|---|---|---|---|---|---|---|
| Processing time | 0 | 3 | 5 | 8 | 10 | 12 | 14 | 16 | 18 | 20 |
| Substrate thickness | 66 | 65 | 65 | 63 | 60 | 58 | 57 | 56 | 54 | 50 |
| Substrate | VT | VT | VT | VT | VT | VT | VT | VT | VT | S |

In Table 1, the processing time is expressed in (minute) and the thickness in (µm) and VT stands for "Upilex -VT" and S for "Upilex -S" respectively.

As the time elapses, the thickness of polyimide resin film substrate reduces, interference fringes due to "Upilex -VT" were observed partially on " Upilex -S" surface until 18 minutes, but interference fringes disappeared after 20 minutes, and "Upilex -S" surface was exposed completely, by which a complete etching of "Upilex -VT" was confirmed. "Upilex -VT" average etching rate was 0.8 µm/minute.

### [Example 2]

A metal plated polyimide resin film substrate (size 5 cm x 5 cm, thickness 37 µm) was manufactured by plating a stainless steel foil of 20 µm in thickness to one face of "Neoflex Series II" made by MITSUI CHEMICAL, INC. (TPI:2 µm/"Apical" of PI:12.5 µm/TPI:2 µm). It should be appreciated that the TPI stands for a thermoplastic polyimide resin and PI non thermoplastic polyimide resin respectively, and "Neoflex Series II" forms a TPI base adhesive layer having the aforementioned thickness on both faces of "Apical".

Then, similarly to the Example 1, the same was soaked in an etching liquid composed of 300 weight parts of monoethanolamine and 100 weight parts of 25% tetra methyl ammonium hydroxide aqueous solution and heated to 80 °C, and the thickness variation of the substrate was measured. The etching liquid was composed of 74.3 wt% of monoethanolamine, and 5.68 wt% of tetra methyl ammonium hydroxide. Table 2 shows the measurement results of the substrate thickness. The substrate thickness was measured by the micrometer (model: 1D-C112) made by MITSUTOYO Corporation.

**Table 2**

| | | | | | | | | | | | |
|---|---|---|---|---|---|---|---|---|---|---|---|
| Processing time | 0 | 1 | 2 | 3 | 4 | 5 | 6 | 7 | 8 | 9 | 10 |
| Substrate thickness | 37 | 36 | 35 | 32 | 30 | 29 | 24 | 22 | 21 | 20 | 20 |
| Substrate | TPI | TPI | TPI | TPI | PI | PI | PI | TPI | TPI | TPI | SUS |

In Table 2, the processing time is expressed in (minute) and the thickness in (µm) and TPI stands for "thermoplastic polyimide resin" and PI "non thermoplastic polyimide resin" respectively. In 8 minutes processing, interference fringes due to polyimide film were observed partially on the stainless steel surface, but interference fringes were not observed at all in 9 minutes and 10 minutes processing, leaving a metallic luster. The etching rate of the TPI was 1 µm/minute and the etching rate of the PI was 2.6 µm/minute.

The etching rate of the latter (PI) corresponding to 1/10 of a commercialized alkali base etching liquid (25 µm/minute), showing, consequently, that the etching is executed slowly and with a better balance compared to conventional alkali base etching liquids.

### [Example 3]

A both faces copper plated polyimide resin film substrate was manufactured by plating a electrolysis copper foil of 9 µm in thickness through a vacuum press to "Upilex -VT" exposed face of "Upisel-N" (Cu : 18 µm/"Upilex -VT":25 µm, size 5 cm x 5 cm) which is a one face copper plated polyimide resin film substrate made by UBE Industries LTD.

It should be appreciated that in the both faces copper plated polyimide resin film substrate, the relief of the electrolysis copper foil rough surface (Max 4 µm) was adhered closely in anchor form to the polyimide resin film substrate, consequently, a high adhesion strength (peel strength of 1.6 kg/cm) was obtained.

Then, a dry film NIT-225 was laminated on both faces of such both faces copper plated polyimide resin film substrate, the electrolysis copper foil side was exposed to the light using a photo mask for forming a wiring pattern of L/S = 30/30, pitch 60 µm and the other side was totally exposed to the light, and then developed, to form an etching mask on the electrolysis copper foil side.

Next, etching processing was performed using an ammonia base copper etching liquid and, thereafter, the dry film was peeled off to form a copper wiring pattern of 15 µm in top width, and 30 µm in bottom width. In this case, some copper residue was observed on the thermoplastic polyimide resin layer in the space section.

Then, the same was processed for 10 minutes in an etching liquid composed of 300 volume parts of monoethanolamine and 100 volume parts of 25% tetra methyl ammonium hydroxide aqueous solution and heated to 70 °C, and the hermoplastic polyimide resin in the space section ("Upilex -VT" ) was removed by etching of about 3 µm in thickness.

Next, a short time thin film etching was performed with an ammonia base copper etching liquid, and copper foil residue remaining in the space section was removed completed by etching of thermoplastic polyimide resin and copper thin film etching.

### [Example 4]

A both faces metal plated polyimide resin film substrate of 5 cm x 5 cm in size was manufactured by plating a copper foil of 18 µm in thickness to one face of "Neoflex Series II" made by MITSUI CHEMICAL, INC. (TPI:2 µm/"Apical" of PI:12.5 µm/TPI:2 µm) and a stainless steel foil of 20 µm in thickness to the other face.

It should be appreciated that the TPI stands for a thermoplastic polyimide resin and PI non thermoplastic polyimide resin respectively, and "Neoflex Series II" forms a TPI base adhesive layer having the aforementioned thickness on both faces of "Apical".

Then, a dry film was laminated on the copper foil side of the both faces metal plated polyimide resin film substrate, exposed to the light, developed to form a trench hole pattern of 100 µm in width. After trenches of 100 µm in width were opened by the ammonia base copper etching liquid, the dry film was peeled off for manufacturing a copper foil mask.

Next, etching processing was performed for 25 minutes using a commercialized etching liquid TPE-3000 made by Toray Engineering Co., Ltd. heated to 80 °C. An enlarged view of the obtained hole is shown in Fig. 1, which is an SEM (Scanning Electron Microscope) picture, and overhanging residue of thermoplastic polyimide was observed in the copper mask section and the stainless steel interface, respectively.

Then, the same was processed for 3 minutes in an etching liquid composed of 300 volume parts of monoethanolamine and 100 volume parts of 25% tetra methyl ammonium hydroxide aqueous solution and heated to 70 °C. An enlarged view of the obtained trench section is shown in Fig. 2, which is an SEM picture, and residue of thermoplastic polyimide resin remaining on the hole peripheral wall was completely removed, and the trench hole peripheral wall is now smooth.

### [Example 5]

A dry film was laminated on both copper foil faces of a both faces copper plated polyimide resin film substrate (5 cm x 5 cm in size) obtained by plating a copper foil of 18 µm in thickness to both faces of "Neoflex Series II" made by MITSUI CHEMICAL, INC. (TPI:2 µm/"Apical" of PI:12.52 µm/TPI:2 µm), exposed to the light and developed to form a resin mask having a copper wiring pattern and a copper device hole formation opening, and then the copper wiring pattern and a copper opening were formed by etching the copper foil with ammonia base etching liquid.

It should be appreciated that the TPI stands for a thermoplastic polyimide resin and PI non thermoplastic polyimide resin respectively, and "Neoflex Series II" forms a TPI base adhesive layer having the aforementioned thickness on both faces of "Apical".

Then, the dray film was removed once, and the dry film was laminated again on the wiring pattern face, to make the same an etching protection mask for the polyimide resin on the wiring pattern side.

Next, etching processing was performed for 3 minutes using the commercialized etching liquid TPE-3000 made by Toray Engineering Co., Ltd. heated to 80 °C.

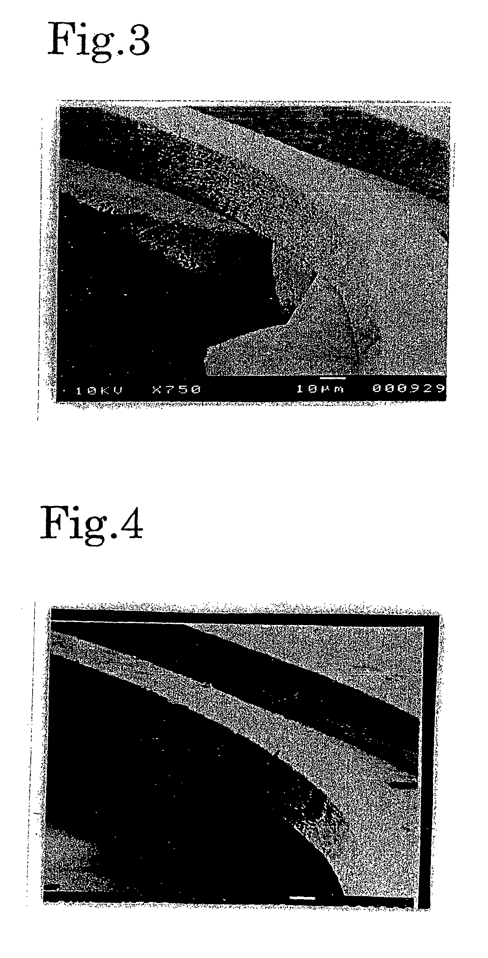

An enlarged view of the obtained open hole (device hole) comprising flying leads is shown in Fig. 3, which is an SEM picture, and residue of thermoplastic polyimide (residue of TPI base adhesion layer) was observed on the copper wiring section and the opening section interface, respectively.

Then, the same was processed for 4 minutes in an etching liquid composed of 300 volume parts of monoethanolamine and 100 volume parts of 25% tetra methyl ammonium hydroxide aqueous solution and heated to 70 °C.

An enlarged view of the open hole (device hole) section is shown in Fig. 4, which is an SEM picture, and residue of thermoplastic polyimide resin remaining on the wiring lower section was completely removed.

### [Example 6]

Results of a processing under the same conditions as the Example 4 except for the temperature of the etching liquid composed of 300 volume parts of monoethanolamine and 100 volume parts of 25% tetra methyl ammonium hydroxide aqueous solution are shown in Table 3. A trench without thermoplastic polyimide resin residue was obtained under a condition in which the temperature of etching liquid is set at either 60 °C or 80 °C.

**Table 3**

| Etching Temperature | Time | State of trench |
|---|---|---|
| 60 °C | 7.5 minutes | Good, smooth peripheral wall without residue |
| 80 °C | 2.0 minutes | ditto |

### [Example 7]

As the results of a processing under the same conditions as the Example 4 except for the temperature of the etching liquid composed of 300 weight parts of monoethanolamine and 100 weight parts of 25% tetra methyl ammonium hydroxide, a trench of smooth peripheral wall without thermoplastic polyimide resin residue was obtained.

Now, comparison examples shall be explained.

### [Comparison Example 1]

It was processed under the same conditions as the Example 1 except for the use of the TPE-3000 which is a commercialized inorganic alkali base etching liquid as etching liquid.

### [Comparison Example 2]

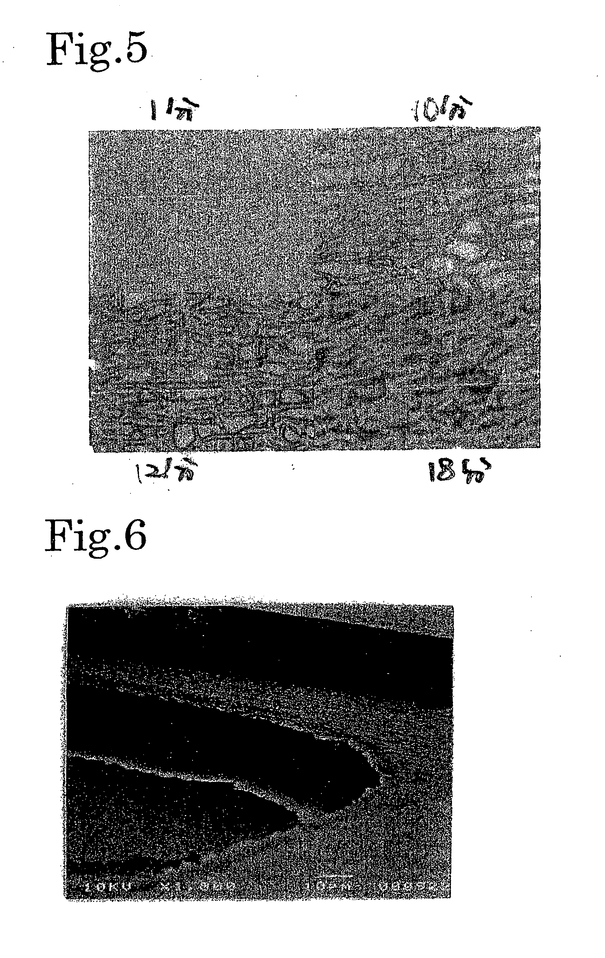

It was processed under the same conditions as the Example 2 except for the use of the TPE-3000 which is a commercialized inorganic alkali base etching liquid as etching liquid. Both in Comparison Examples 1 and 2, their etching rate was faster than that of Examples 1 and 2, the etching rate difference between non thermoplastic polyimide resin and thermoplastic polyimide resin was large and, furthermore, in the Comparison Example 1 related to "Upilex-VT"/"Upilex-S", thermoplastic polyimide resin is removed unevenly, the gloss of polyimide face was lost in 3 minutes processing, and as shown in Fig. 5 which is an SEM picture, the polyimide resin surface became rough in 10 minutes processing. In Fig. 5, the left upper section shows the surface after 1 minute processing, the right upper section the surface after 10 minutes processing, the right lower section the surface after 18 minutes processing, and the left bottom section the surface after 21 minutes processing.

Moreover, as the etching of non thermoplastic polyimide resin proceeds at the same time, the boundary between the "Upilex-VT" and "Upilex-S" could not be distinguished. Results of the film thickness measurement in the Comparison Example 1 is shown in [Table 4] and at the same time, results of the film thickness measurement in the Comparison Example 2 is shown in [Table 5].

**Table 4**

| | | | | | | | | | | |
|---|---|---|---|---|---|---|---|---|---|---|
| Processing time | 0 | 2 | 3 | 5 | 8 | 10 | 12 | 14 | 16 | 18 |
| Substrate thickness | 66 | 67 | 66 | 66 | 64 | 63 | 59 | 58 | 54 | 39 |
| Substrate | VT | VT | VT | VT | VT | VT | VT | VT | VT | S |

**Table 5**

| | | | | | | | |
|---|---|---|---|---|---|---|---|
| Processing time | 0 | 0.5 | 1 | 1.5 | 2 | 3 | 4 |
| Substrate thickness | 37 | 35 | 22 | 22 | 23 | 21 | 20 |
| Substrate | TPI | TPI | PI | PI | TPI | TPI | SUS |

In Table 4, the processing time is expressed in (minute) and the thickness in (µm) and VT stands for "Upilex -VT" and S for "Uplix -S" respectively. In addition, in Table 5, the processing time is expressed in (minute) and the thickness in (µm) and TPI stands for thermoplastic polyimide resin and PI for non thermoplastic polyimide resin respectively.

### [Comparison Example 3]

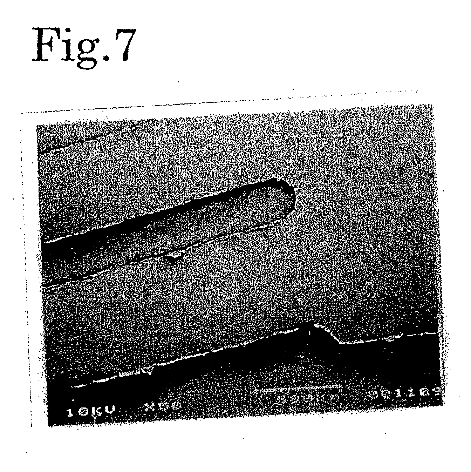

It was processed under the same conditions as the Example 4 except for a longer etching time by the TPE-3000 in place of the etching by the etching liquid composed of 300 volume parts of monoethanolamine and 100 volume parts of 25% tetra methyl ammonium hydroxide, and as shown in Fig. 6 which is an SEM picture, such a trench peripheral wall where only "Apical" (non thermoplastic polyimide resin) sandwiched by thermoplastic polyimide resin was etched was obtained, due to difference in the resin etching rates (thermoplastic polyimide resin is harder to be etched than non thermoplastic polyimide resin).

### [Comparison Example 4]

The polyimide resin film substrate presenting thermoplastic polyimide resin residue around the trench wall section etched by the TPE-3000 in the Example 4 was processed for 5 minutes with the etching liquid of 70 °C composed of 300 volume parts of isopropyl alcohol, 100 volume parts of 25% tetra methyl ammonium hydroxide aqueous solution and 50 volume parts of water, according to the method described in the Description of US Patent No. 4426253, and as shown in Fig. 7 which is an SEM picture, thermoplastic polyimide resin residue around the trench wall section could not be removed.

### INDUSTRIAL APPLICABILITY

As mentioned hereinabove, according to the present invention, an etching liquid appropriate for etching thermoplastic polyimide resins.

In short, when an etching liquid composed of an aliphatic amino-alcohol whose number of carbon is equal or inferior to 4 having an amino group or imino group and a hydroxyl group in the molecular, and a tetra alkyl ammonium hydroxide aqueous solution, according to the present invention, is used, it is possible "to etch in a way to give priority to the etching of thermoplastic polyimide resin over the etching of non thermoplastic polyimide resin and, furthermore, to keep the progress balance of both etchings substantially constant" that has been difficult for conventional etching liquids, and whereby, particularly, the general use of metal plated polyimide film substrate using thermoplastic polyimide resin base adhesive can be promoted furthermore.

## Claims

1. An etching liquid for thermoplastic polyimide resin, composed of an aliphatic amino alcohol whose number of carbon is not more than 4 having one of an amino group and an imino group as well as a hydroxyl group in a molecular thereof and an aqueous solution of tetra alkyl ammonium hydroxide.

2. The etching liquid for thermoplastic polyimide resin of claim 1, **characterized by** that said aliphatic amino alcohol is monoethanolamine while said aqueous solution of tetra alkyl ammonium hydroxide is one of an aqueous solution of tetra methyl ammonium hydroxide and an aqueous solution of tetra ethyl ammonium hydroxide.

3. The etching liquid for thermoplastic polyimide resin of claim 1, **characterized by** that said aliphatic amino alcohol is monoethanolamine while said aqueous solution of tetra alkyl ammonium hydroxide is an aqueous solution of tetra methyl ammonium hydroxide, and the content amount of tetra methyl ammonium hydroxide is 4wt% to 15wt%.
